# EUROPEAN PATENT SPECIFICATION

(11) **EP 4 395 152 B1**
(45) Date of publication and mention of the grant of the patent: **30.09.2026**
(21) Application number: 22875745.6
(22) Date of filing: 07.09.2022
(51) Int. Cl.: H02M 7/5387, H02M 7/00, H02M 1/12, H02M 1/44, H02G 5/00, H05K 7/14, H10D 84/00

(54) **POWER MODULE**
LEISTUNGSMODUL
MODULE DE PUISSANCE

(30) Priority: 01.10.2021 JP 2021162989
(43) Date of publication of application: 03.07.2024
(73) Proprietor: Mitsubishi Heavy Industries, Ltd., Tokyo 100-8332 (JP)
(72) Inventor: MASUZAWA, Takashi, Tokyo 100-8332 (JP); EZUMI, Masahiko, Tokyo 100-8332 (JP); YANAGITA, Norihito, Tokyo 100-8332 (JP)
(74) Representative: Studio Torta S.p.A.
(86) International application number: PCT/JP2022/033564
(87) International publication number: WO 2023/053873

(56) References cited:
- WO-A1-2021/042348
- JP-A- 2013 017 359
- JP-A- 2013 098 425
- JP-A- 2014 017 988
- US-A1- 2010 181 876
- US-A1- 2013 265 808
- US-A1- 2018 206 359
- US-A1- 2019 206 810

## Description

### Technical Field

The present disclosure relates to a power module.

Priority is claimed on Japanese Patent Application No. 2021-162989, filed October 1, 2021.

### Background Art

Patent Document 1 discloses a power semiconductor module (hereinafter, referred to as a power module) used in a power conversion device of a hybrid vehicle or an electric vehicle. In the field of power modules, in order to achieve both high current and high-speed switching in power conversion devices, there is a need to reduce parasitic inductance generated in wiring conductors connected to power semiconductor elements.

For example, in a power circuit on an insulating substrate in the power module described in Patent Document 1, two loops are formed in the clockwise and counterclockwise directions of the recovery current flowing from a positive terminal to a negative terminal and from the negative terminal to the positive terminal. Accordingly, the parasitic inductance generated in the power circuit of the power module is reduced by canceling out mutually generated magnetic flux.

### Citation List

### Patent Document

Patent Document 1: Japanese Unexamined Patent Application, First Publication Other prior art documents are: US 2019/206810 A1, US 2018/206359 A1, US 2013/265808 A1, US 2010/181876 A1 and WO 2021/042348 A1.

### Summary of Invention

### Technical Problem

Incidentally, in Patent Document 1, the positive and negative terminals for supplying power to the power circuit are separated from each other. Therefore, there is a problem that parasitic inductance increases in the input side conductor that supplies power to the power circuit.

The present disclosure has been made to solve the above-described problems and an object thereof is to provide a power module capable of reducing parasitic inductance occurring in an input side conductor.

### Solution to Problem

The invention is defined by the features of device claim 1. The dependent claims recite advantageous embodiments of the invention.

### Advantageous Effects of Invention

According to the present disclosure, it is possible to provide a power module capable of reducing parasitic inductance occurring in an input side conductor.

### Brief Description of Drawings

FIG. 1 is a perspective view illustrating a schematic configuration of a power conversion device according to an embodiment of the present disclosure.
FIG. 2 is a perspective view of a power module according to a first embodiment of the present disclosure.
FIG. 3 is an enlarged view of a main part of FIG. 2 and illustrates a state in which a reinforcing portion is removed.
FIG. 4 is a partially cross-sectional view taken along a line III-III illustrated in FIGS. 2 and 3 and is a view illustrating a positional relationship between a magnetic flux reduction conductor and an input section.
FIG. 5 is a partially cross-sectional view of a power module according to a second embodiment of the present disclosure and is a view illustrating a positional relationship between a magnetic flux reduction conductor and an input section.
FIG. 6 is a partially cross-sectional view of a power module according to another embodiment of the present disclosure and is a view illustrating a positional relationship between a magnetic flux reduction conductor and a connection portion.

### Description of Embodiments

### [First embodiment] (Power conversion device)

Hereinafter, a power conversion device according to this embodiment will be described with reference to the drawings.

The power conversion device of this embodiment is a device that converts DC power into three-phase AC power or the like. Examples of the power conversion device of this embodiment include an inverter used in a system such as a power plant, an inverter used to drive an electric motor of an electric vehicle, and the like. In this embodiment, an inverter for controlling an electric motor will be described as an example of the power conversion device.

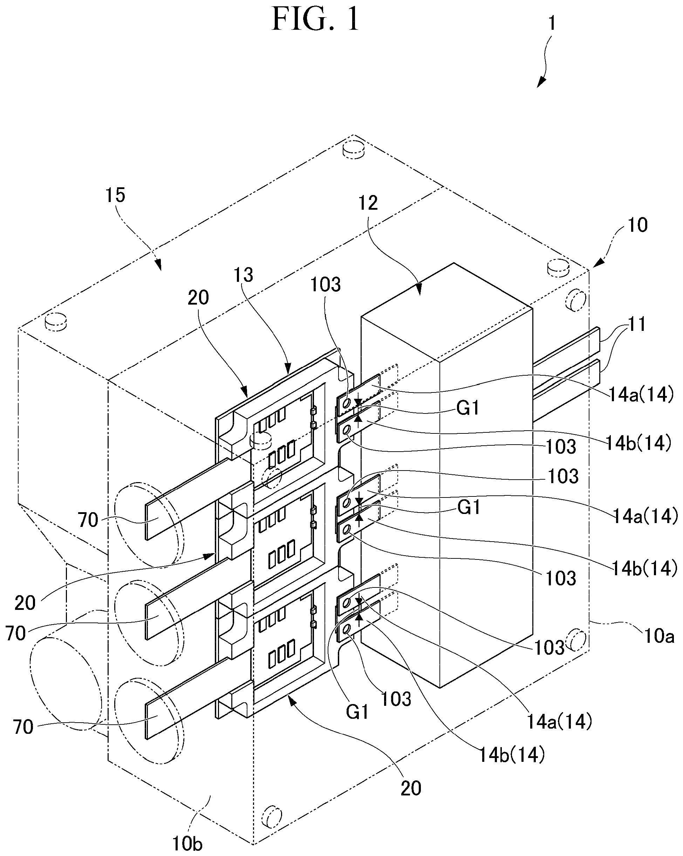

As illustrated in FIG. 1, a power conversion device 1 includes a casing 10, an external input conductor 11, a capacitor 12, a connection conductor 14, a power conversion unit 13, and a cooling device 15.

### (Casing)

The casing 10 forms the outer shell of the power conversion device 1. The casing 10 illustrated in this embodiment is made of metal such as aluminum or synthetic resin and has a rectangular parallelepiped shape. The casing 10 includes two side surfaces (hereinafter, referred to as an input side surface 10a and an output side surface 10b) that are arranged back to back to each other. The external input conductor 11 for inputting DC power is drawn out from the input side surface 10a.

### (External input conductor)

The external input conductor 11 is an electrical conductor that supplies the capacitor 12 with DC power supplied from a DC power supply provided outside the power conversion device 1. The external input conductor 11 of this embodiment is an electrical conductor (bus bar) made of metal including copper or the like. One end of the external input conductor 11 is connected to the capacitor 12 and the other end thereof extends in a direction intersecting the input side surface 10a of the casing 10.

### (Capacitor)

The capacitor 12 is a smoothing capacitor that stores the charge input from the external input conductor 11 and suppresses voltage fluctuations associated with power conversion. The smoothed DC voltage with ripples suppressed is supplied to the power conversion unit 13 via the capacitor 12 .

### (Power conversion unit)

The power conversion unit 13 converts the voltage input from the capacitor 12. The power conversion unit 13 of this embodiment includes three power modules 20 to output three-phase AC power. The configuration of the power module 20 of this embodiment will be described in detail later.

### (Connection conductor)

The connection conductor 14 is an electrical conductor (bus bar) for transmitting power from the capacitor 12 to the power conversion unit 13. One end of the connection conductor 14 is connected to the capacitor 12 (detailed illustration of the connection state between the connection conductor 14 and the capacitor 12 is omitted). The other end of the connection conductor 14 is connected to the power module 20. A fastening hole 103 for fastening a bolt is formed at the other end of the connection conductor 14 of this embodiment.

The connection conductor includes a first connection conductor 14a and a second connection conductor 14b.

The first connection conductor 14a is a current path that connects a positive electrode (not illustrated) of the capacitor 12 and a positive electrode of the power module 20. The second connection conductor 14b is a current path that connects a negative electrode (not illustrated) of the capacitor 12 and a negative electrode of the power module 20. The first connection conductor 14a and the second connection conductor 14b are arranged side by side.

Hereinafter, a gap generated between the first connection conductor 14a and the second connection conductor 14b arranged side by side is referred to as a gap G1. In other words, the second connection conductor 14b is arranged in parallel to the first connection conductor 14a with the gap G1 interposed therebetween. An insulation distance is ensured in the gap G1 so that the current flowing through the first connection conductor 14a does not flow to the second connection conductor 14b or the current flowing through the second connection conductor 14b does not flow to the first connection conductor 14a. The insulation distance in this embodiment is preferably 1 mm or more and 10 mm or less.

### (Cooling device)

The cooling device 15 is a device that mainly cools the power module 20 of the power conversion unit 13. The cooling device 15 is provided to be stacked on the casing 10 and is fixed and integrated with the casing 10. A liquid refrigerant such as water is introduced into the cooling device 15 from the outside.

### (Power module)

The power module 20 is a device that converts input power and outputs the converted power. The power module 20 of this embodiment constitutes part of the power conversion unit 13.

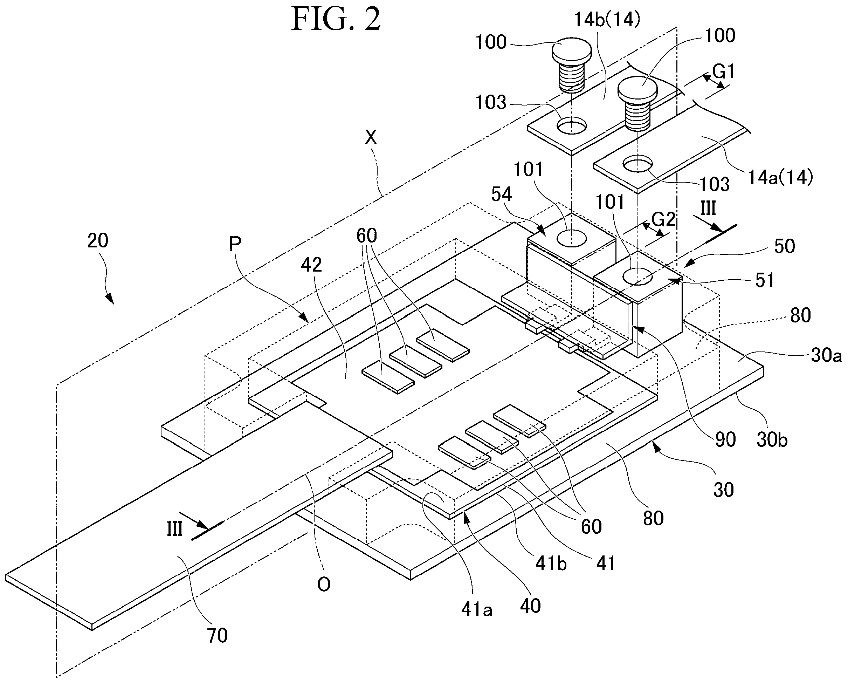

As illustrated in FIGS. 2, 3, and 4, the power module 20 includes a base plate 30, a circuit board 40, an input section 50, an external output conductor 70 (output conductor), a reinforcing portion 80, and a magnetic flux reduction conductor 90.

### (Base plate)

The base plate 30 is a member having a flat plate shape. The base plate 30 includes a first surface 30a and a second surface 30b located on the back side of the first surface 30a. That is, the first surface 30a and the second surface 30b of the base plate 30 are parallel to each other and are placed back to back. The second surface 30b of the base plate 30 is fixed to, for example, the cooling device 15 via a bonding material or the like (not illustrated). For example, copper is used for the base plate 30 in this embodiment. Furthermore, the base plate 30 may be made of a metal other than copper.

### (Circuit board)

The circuit board 40 includes a circuit board body 41, a copper pattern 43, a circuit pattern 42, and a power semiconductor element 60.

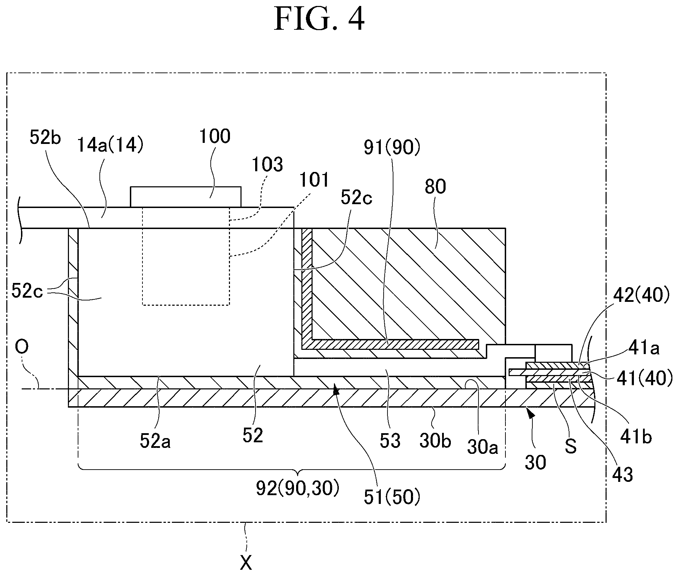

The circuit board body 41 has a flat plate shape. The circuit board body 41 includes a front surface 41a and a back surface 41b located on the back side of the front surface 41a. That is, the front surface 41a and the back surface 41b of the circuit board body 41 are parallel to each other and are placed back to back. As illustrated in FIG. 4, the copper pattern 43, which is a pattern of copper foil or the like, is formed on the back surface 41b of the circuit board body 41. The copper pattern 43 is fixed to the center of the first surface 30a of the base plate 30 via a bonding material S or the like.

The circuit board body 41 is made of an insulating material such as ceramic. Furthermore, as the insulating material forming the circuit board body 41, paper phenol, paper epoxy, glass composite, glass epoxy, glass polyimide, fluororesin, and the like can be used in addition to ceramics.

The circuit pattern 42 is a pattern of copper foil or the like formed on the front surface 41a of the circuit board body 41. The circuit pattern 42 of this embodiment is formed by, for example, being fixed to the front surface 41a of the circuit board body 41 by adhesive or the like, and then etching or the like. In the circuit pattern 42 of this embodiment, an input circuit (not illustrated), an output circuit (not illustrated), and a control circuit (not illustrated) are formed.

The input circuit is a circuit pattern for inputting power input from the outside to the power semiconductor element 60. The output circuit is a circuit pattern for outputting the power converted by the power semiconductor element 60. The control circuit is a circuit pattern to which a control unit (not illustrated) that generates a control signal for controlling the behavior of the power semiconductor element 60 is connected.

The power semiconductor element 60 is a circuit element that converts power through a switching operation that turns on and off voltage and current. The power semiconductor element is, for example, a switching element such as an IGBT or a MOSFET. In this embodiment, six power semiconductor elements 60 are mounted on the circuit pattern 42 of the circuit board 40.

When the power semiconductor element 60 is an IGBT, the power semiconductor element 60 includes an input surface (not illustrated) corresponding to a collector, an output surface (not illustrated) corresponding to an emitter, and a gate (not illustrated) corresponding to a control signal input terminal for controlling the switching of the power semiconductor element 60.

The input surface of the power semiconductor element 60 is electrically connected to the input circuit of the circuit pattern 42 formed on the front surface 41a of the circuit board body 41 via a bonding material or the like.

For example, one end of a lead frame (not illustrated) as a conducting wire is electrically connected to the output surface of the power semiconductor element 60. The other end of the lead frame is electrically connected to the output circuit of the circuit pattern 42.

That is, DC current is input to the input terminal (not illustrated) via the circuit pattern 42, DC voltage is converted into AC voltage by the power semiconductor element 60, and AC power is output from the output terminal (not illustrated). A control signal generated by the control unit (not illustrated) is input to the power semiconductor element 60. The power semiconductor element 60 performs switching according to the control signal.

Furthermore, when the power semiconductor element 60 is a MOSFET, the power semiconductor element 60 includes an input surface corresponding to a drain, an output surface corresponding to a source, and a gate corresponding to a control signal input terminal.

For example, solder, sintered material (powder of metal or the like), or the like can be used as a bonding material for the bonding between the base plate 30 and the copper pattern 43 formed on the back surface 41b of the circuit board body 41, the bonding between the power semiconductor element 60 and the circuit pattern 42, and the bonding between the base plate 30 and the cooling device 15.

### (Input section)

The input section 50 is a current path for receiving current input from the capacitor 12 and passing DC current to the circuit pattern 42 of the circuit board 40.

The input section 50 includes a first input conductor 51 and a second input conductor 54 as two terminals forming a PN terminal. The first input conductor 51 and the second input conductor 54 are provided in parallel with a gap therebetween in a direction along the base plate 30. More specifically, the first input conductor 51 and the second input conductor 54 have the same shape and size, and are arranged symmetrically in parallel with respect to a reference plane X.

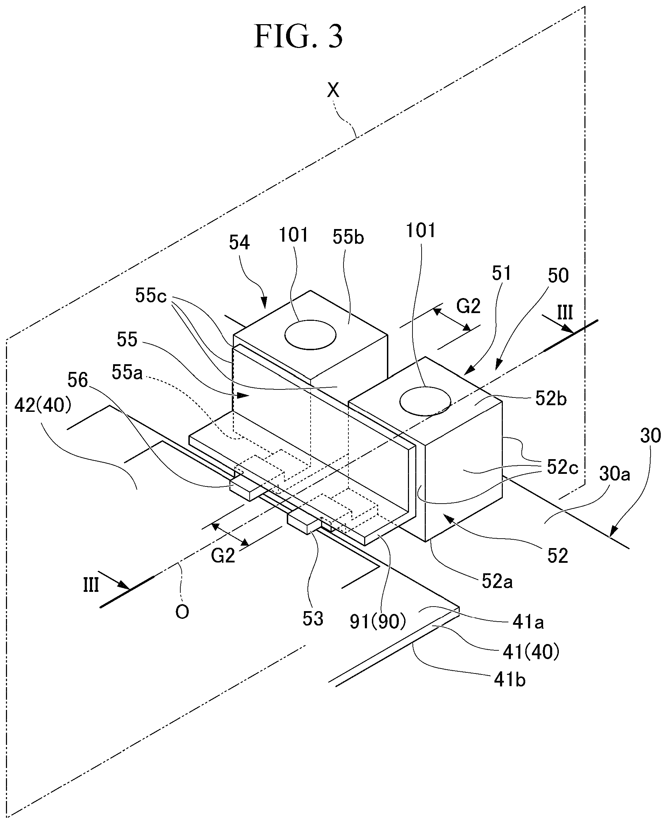

As illustrated in FIGS. 2 and 3, the reference plane X of this embodiment is a virtual plane that extends in a direction perpendicular to the direction in which the base plate 30 spreads and divides the base plate 30 into two equal parts. Hereinafter, an imaginary line where the reference plane X and the first surface 30a of the base plate 30 intersect is referred to as a reference line O. In this embodiment, the direction on the first surface 30a of the base plate 30 toward the input section 50 from the circuit board 40 is referred to as one side in the direction of the reference line O, and the opposite direction is referred to as the other side in the direction of the reference line O.

The first input conductor 51 is an electrical conductor serving as a positive electrode that transmits power to the power semiconductor element 60 of the circuit board 40. The first input conductor 51 is made of metal such as copper. The first input conductor 51 includes a P-type terminal 52 and a first input connection portion 53.

The P-type terminal 52 has a rectangular parallelepiped shape and serves as part of the current path of the input current. The P-type terminal 52 includes a first proximal end surface 52a, a first distal end surface 52b, and a first side surface 52c which connects the first proximal end surface 52a and the first distal end surface 52b.

The first proximal end surface 52a is facing the first surface 30a of the base plate 30 at a distance from the first surface 30a.

The first distal end surface 52b is a surface located on the opposite side of the first proximal end surface 52a and faces in a direction away from the base plate 30. That is, the first distal end surface 52b and the first proximal end surface 52a are in a back-to-back relationship and in parallel to each other. The first connection conductor 14a electrically connected to the capacitor 12 can be fixed to the first distal end surface 52b. That is, the P-type terminal 52 is connected to the capacitor 12 as a DC power supply via the first connection conductor 14a.

A screw hole 101 for fastening a bolt is formed on the first distal end surface 52b of this embodiment. Since the screw hole 101 is formed, the first connection conductor 14a which is an external conductor for inputting current can be fastened to the first distal end surface 52b by a bolt 100.

The first side surface 52c is a surface which extends in a direction away from the first surface 30a of the base plate 30 and connects the first proximal end surface 52a and the first distal end surface 52b. The first side surface 52c of this embodiment extends from the first proximal end surface 52a in a direction perpendicular to the first surface 30a of the base plate 30 and reaches the first distal end surface 52b. The current flowing from the first distal end surface 52b of the P-type terminal 52 flows from the first distal end surface 52b toward the first proximal end surface 52a. Furthermore, in this embodiment, the outline of the P-type terminal 52 in a cross section perpendicular to the direction in which the first side surface 52c extends has a rectangular shape (specifically, a square shape).

The first input connection portion 53 is an electrical conductor which connects the P-type terminal 52 and the circuit board 40 and serves as part of the current path of the input current. The first input connection portion 53 of this embodiment extends from an end portion on the side of the first proximal end surface 52a of the first side surface 52c of the P-type terminal 52 and is connected to the input circuit of the circuit pattern 42 of the circuit board 40.

Thus, the current flowing through the P-type terminal 52 flows into the first input connection portion 53 and then flows into the input circuit of the circuit pattern 42 of the circuit board 40 via the first input connection portion 53.

The second input conductor 54 is an electrical conductor serving as a negative electrode that transmits power to the power semiconductor element 60 of the circuit board 40. The second input conductor 54 is made of metal such as copper. The second input conductor 54 includes a N-type terminal 55 and a second input connection portion 56.

The N-type terminal 55 has a rectangular parallelepiped shape like the P-type terminal 52 and serves as part of the current path of the input current. The N-type terminal 55 includes a second proximal end surface 55a, a second distal end surface 55b, and a second side surface 55c which connects the second proximal end surface 55a and the second distal end surface 55b.

The second proximal end surface 55a is a surface which faces the first surface 30a at a distance from the first surface 30a of the base plate 30.

The second distal end surface 55b is a surface which is located on the side opposite to the second proximal end surface 55a and faces a direction away from the base plate 30. That is, the second distal end surface 55b and the second proximal end surface 55a are in a back-to-back relationship in parallel to each other.

The second connection conductor 14b electrically connected to the capacitor 12 can be fixed to the second distal end surface 55b. That is, the N-type terminal 55 is connected to the capacitor 12 serving as a DC power supply via the second connection conductor 14b together with the P-type terminal 52. The screw hole 101 for fastening a bolt is formed on the second distal end surface 55b of this embodiment. Since the screw hole 101 is formed, the second connection conductor 14b which is an external conductor for inputting current can be fastened to the second distal end surface 55b by the bolt 100.

The second side surface 55c is a surface which extends in a direction away from the first surface 30a of the base plate 30 and connects the second proximal end surface 55a and the second distal end surface 55b. The second side surface 55c of this embodiment extends in a direction perpendicular to the front surface 41a of the base plate 30 from the second proximal end surface 55a and reaches the second distal end surface 55b.

The current flowing from the second distal end surface 55b of the N-type terminal 55 flows from the second distal end surface 55b toward the second proximal end surface 55a. Furthermore, in this embodiment, the outline of the N-type terminal 55 in a cross section perpendicular to the direction in which the second side surface 55c extends has a rectangular shape (specifically, a square shape).

The second input connection portion 56 is an electrical conductor which connects the N-type terminal 55 and the circuit board 40 and serves as part of the current path of the input current. The second input connection portion 56 extends from an end portion on the side of the second proximal end surface 55a of the second side surface 55c of the N-type terminal 55 and is connected to the input circuit of the circuit pattern 42 of the circuit board 40.

Thus, the current flowing through the N-type terminal 55 flows into the second input connection portion 56 and flows into the circuit pattern 42 of the circuit board 40 via the second input connection portion 56.

The P-type terminal 52 and the N-type terminal 55 are arranged to be symmetrical to the first input connection portion 53 and the second input connection portion 56 with respect to the reference plane X. Hereinafter, a gap generated between the P-type terminal 52 and the N-type terminal 55, and the first input connection portion 53 and the second input connection portion 56 arranged side by side is referred to as a gap G2.

In other words, the second input conductor 54 is provided in parallel to the first input conductor 51 with the gap G2 interposed therebetween. An insulation distance is ensured in the gap G2 so that the current flowing through the first input conductor 51 does not flow to the second input conductor 54 or the current flowing through the second input conductor 54 does not flow to the first input conductor 51. The insulation distance in this embodiment is preferably 1 mm or more and 10 mm or less.

### (External output conductor)

As illustrated in FIG. 2, the external output conductor 70 is an output bus bar which receives the current output from the power semiconductor element 60 and outputs the current to the outside of the power conversion device 1. One end of the external output conductor 70 is connected to the output circuit of the circuit pattern 42 of the circuit board 40. As illustrated in FIG. 1, the other end of the external output conductor 70 penetrates the output side surface 10b of the casing 10 and extends outward. For example, a current output wire or the like (not illustrated) is connected to the other end of the external output conductor 70. Accordingly, it is possible to output AC power to the outside of the power conversion device 1.

### (Reinforcing portion)

The reinforcing portion 80 is a member that is fixed to the first surface 30a of the base plate 30 and mechanically reinforces the input section 50 and the external output conductor 70. The reinforcing portion 80 is made of a synthetic resin material. The reinforcing portion 80 covers the first input connection portion 53 and the first side surface 52c of the P-type terminal 52 and the second input connection portion 56 and the second side surface 55c of the N-type terminal 55 from the outside and surrounds the circuit board 40 at least from the outside. That is, as illustrated in FIG. 2, the reinforcing portion 80 forms a casing that surrounds the circuit board 40 in the direction along the circuit board 40.

The reinforcing portion 80 is fixed to the first surface 30a of the base plate 30 via adhesive or the like. For example, an insulating material such as polyphenylene sulfide (PPS) can be used as a synthetic resin material for the reinforcing portion 80 in this embodiment. Furthermore, an insulating material other than PPS may be used for the reinforcing portion 80.

The reinforcing portion 80 defines a space together with the circuit board 40. Hereinafter, in this embodiment, a space defined by the reinforcing portion 80 and the circuit board 40 is referred to as a potting space P. A liquid potting material is poured into the potting space P from the outside (potting) to seal at least the circuit pattern 42 of the circuit board body 41, the power semiconductor element 60, and part of the first input connection portion 53 and the second input connection portion 56 exposed inside the potting space P.

The potting material poured into the potting space P hardens over a predetermined period of time to electrically insulate the circuit pattern 42 of the circuit board 40 and the power semiconductor element 60 from the space outside the power module 20. For example, silicon gel or epoxy resin can be used as the potting material in this embodiment. Furthermore, a synthetic resin other than silicone gel or epoxy resin may be used as the potting material.

### (Magnetic flux reduction conductor)

The magnetic flux reduction conductor 90 is a metal conductor provided to reduce parasitic inductance occurring in the input section 50.

As illustrated in FIG. 4, the magnetic flux reduction conductor 90 includes a first magnetic flux reduction conductor 91 and a second magnetic flux reduction conductor 92.

The first magnetic flux reduction conductor 91 is disposed on the side opposite to the base plate 30 in the input section 50. The first magnetic flux reduction conductor 91 is embedded inside the reinforcing portion 80 by insert molding or the like. The first magnetic flux reduction conductor 91 has an L-shaped cross-section when viewed from the reference plane X and is extended in a direction in which the first input conductor 51 and the second input conductor 54 (not illustrated in FIG. 4) are adjacent to each other while having an L-shape.

The first magnetic flux reduction conductor 91 covers each of the gap G2 defined by the P-type terminal 52 and the N-type terminal 55 (not illustrated in FIG. 4) and the gap G2 defined by the first input connection portion 53 and the second input connection portion 56 (not illustrated in FIG. 4). That is, the first magnetic flux reduction conductor 91 is disposed opposite to the input section 50 in an electrically insulated state to cover the gap G2 over the first input conductor 51 and the second input conductor 54. The reinforcing portion 80 is interposed between the first magnetic flux reduction conductor 91 and the input section 50 and the reinforcing portion 80 ensures an insulating distance between the first magnetic flux reduction conductor 91 and the input section 50.

The second magnetic flux reduction conductor 92 constitutes part of the base plate 30. More specifically, the second magnetic flux reduction conductor 92 is a portion that faces the first input conductor 51 and the second input conductor 54 in the base plate 30 on one side of the direction of the reference line O in relation to the circuit board 40.

The second magnetic flux reduction conductor 92 covers each of the gap G2 between the P-type terminal 52 and the N-type terminal 55 and the gap G2 between the first input connection portion 53 and the second input connection portion 56. That is, the second magnetic flux reduction conductor 92 is disposed in opposite to the input section 50 in an electrically insulated state to cover the gap G2 over the first input conductor 51 and the second input conductor 54. The reinforcing portion 80 is interposed between the second magnetic flux reduction conductor 92 and the input section 50 and the reinforcing portion 80 ensures an insulating distance between the second magnetic flux reduction conductor 92 and the input section 50.

### (Operation and effect)

The current supplied from the capacitor 12 to the input section 50 via the connection conductor 14 flows through the input section 50 and then flows toward the power semiconductor element 60 of the circuit board 40. At this time, the magnetic fields generated in the first input conductor 51 and the second input conductor 54 as the current flows affect each other, and the magnetic fluxes forming these magnetic fields cancel each other out. On the other hand, the magnetic flux leaks from the gap G2 between the first input conductor 51 and the second input conductor 54.

In the power module 20 according to the above-described embodiment, the magnetic flux reduction conductor 90 is disposed opposite to the input section 50 in an insulated state to cover the gap G2 over the first input conductor 51 and the second input conductor 54. Accordingly, the magnetic flux reduction conductor 90 is affected by the magnetic flux leaking from this gap G2, and an eddy current as an induced current flows through the magnetic flux reduction conductor 90. Then, this eddy current generates a magnetic flux that cancels out the magnetic flux generated in the input section 50. Thus, the magnetic flux reduction conductor 90 can form a magnetic field that corresponds to the magnitude of the current flowing through the input section 50, that is, the magnitude of the magnetic field, and can reduce parasitic inductance that occurs in the input side conductor.

Further, in the power module 20 according to the above-described embodiment, the magnetic flux reduction conductor 90 includes the first magnetic flux reduction conductor 91 and the second magnetic flux reduction conductor 92 which are arranged to sandwich the input section 50. Accordingly, the magnetic flux reduction conductor 90 can more effectively cancel the magnetic flux leaking from the gap G2. Thus, parasitic inductance generated in the input side conductor can be reduced more efficiently.

Further, in the power module 20 according to the above-described embodiment, the first magnetic flux reduction conductor 91 is disposed on the side opposite to the base plate 30 of the input section 50 and the second magnetic flux reduction conductor 92 is part of the base plate 30. Accordingly, the base plate 30 to which the circuit board 40 is fixed can be used as the magnetic flux reduction conductor 90. Thus, the magnetic flux leaking from the input section 50 can be effectively canceled without requiring major design changes or adding new members.

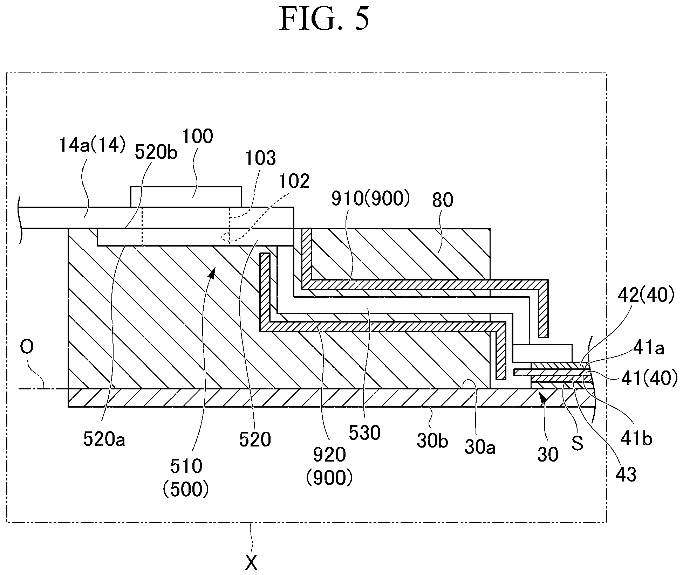

[Second embodiment] Hereinafter, the power module 20 according to a second embodiment of the present disclosure will be described with reference to FIG. 5. The configurations of an input section 500 and a magnetic flux reduction conductor 900 described in the second embodiment are partially different from the configurations of the input section 50 and the magnetic flux reduction conductor 90 described in the first embodiment. Components similar to those in the first embodiment are indicated by the same reference numerals and detailed descriptions are omitted.

### (Input section)

The input section 500 is a current path that passes current input from the capacitor 12 to the circuit pattern 42 of the circuit board 40. The input section 500 includes a first input conductor 510 and a second input conductor 540 (not illustrated in FIG. 5) as two terminals forming a PN terminal. The first input conductor 510 includes a P-type terminal 520 and a first input connection portion 530 and the second input conductor 540 includes a N-type terminal 550 and a second input connection portion 560.

The P-type terminal 520 has a flat plate shape and serves as part of the current path of the input current. The P-type terminal 520 includes a first proximal end surface 520a and a first distal end surface 520b.

The first proximal end surface 520a is a surface that faces the first surface 30a of the base plate 30.

The first distal end surface 520b is a surface that is located on the side opposite to the first proximal end surface 520a. That is, the first distal end surface 520b and the first proximal end surface 520a are in a back-to-back relationship in parallel to each other.

The P-type terminal 520 is provided with a fastening hole 102 that penetrates from the first distal end surface 520b toward the first proximal end surface 520a. Since the fastening hole 102 is formed in the P-type terminal 520, the first connection conductor 14a which is an external conductor for inputting current can be fastened to the P-type terminal 520 by the bolt 100.

The first input connection portion 530 is an electrical conductor which connects the P-type terminal 520 and the circuit board 40 and serves as part of the current path of the input current. The first input connection portion 530 extends from the first proximal end surface 520a of the P-type terminal 520 and is connected to the input circuit of the circuit pattern 42 of the circuit board 40.

The N-type terminal 550 (not illustrated in FIG. 5) has a flat plate shape like the P-type terminal 520 and serves as part of the current path of the input current. The N-type terminal 550 includes a second proximal end surface 550a and a second distal end surface 550b.

The second proximal end surface 550a is a surface that faces the first surface 30a of the base plate 30.

The second distal end surface 550b is a surface which is located on the side opposite to the second proximal end surface 550a. That is, the second distal end surface 550b and the second proximal end surface 550a are in a back-to-back relationship in parallel to each other.

The N-type terminal 550 is provided with the fastening hole 102 that penetrates from the second distal end surface 550b toward the second proximal end surface 550a. Since the fastening hole 102 is formed in the P-type terminal 520, the second connection conductor 14b which is an external conductor for inputting current can be fastened to the N-type terminal 550 by the bolt 100.

The second input connection portion 560 (not illustrated in FIG. 5) is an electrical conductor which connects the N-type terminal 550 and the circuit board 40 and serves as part of the current path of the input current. The second input connection portion 560 extends from the second proximal end surface 550a of the N-type terminal 550 and is connected to the input circuit of the circuit pattern 42 of the circuit board 40.

### (Magnetic flux reduction conductor)

The magnetic flux reduction conductor 900 is a member of a conductor provided inside the reinforcing portion 80. The magnetic flux reduction conductor 900 is embedded in the reinforcing portion 80 by insert molding or the like.

The magnetic flux reduction conductor 900 includes a first magnetic flux reduction conductor 910 and a second magnetic flux reduction conductor 920.

The first magnetic flux reduction conductor 910 is disposed on the side opposite to the base plate 30 of the input section 500. The first magnetic flux reduction conductor 910 has a shape extending along the first input connection portion 530 and the second input connection portion 560 in a cross-sectional view in a direction in which the first input conductor 510 and the second input conductor 540 are adjacent to each other. The first magnetic flux reduction conductor 910 extends in a direction in which the first input conductor 510 and the second input conductor 540 are adjacent to each other while maintaining the shape.

The first magnetic flux reduction conductor 910 covers the gap G2 between the first input connection portion 530 and the second input connection portion 560. That is, the first magnetic flux reduction conductor 910 is disposed opposite to the input section 500 in an electrically insulated state to cover the gap G2 over the first input conductor 510 and the second input conductor 540. The reinforcing portion 80 is interposed between the first magnetic flux reduction conductor 910 and the input section 500 and the reinforcing portion 80 ensures an insulating distance between the first magnetic flux reduction conductor 910 and the input section 500.

The second magnetic flux reduction conductor 920 is disposed between the input section 500 and the base plate 30. The second magnetic flux reduction conductor 920 has a shape extending along the first input connection portion 530 and the second input connection portion 560 in a cross-sectional view in a direction in which the first input conductor 510 and the second input conductor 540 are adjacent to each other. The second magnetic flux reduction conductor 920 extends in a direction in which the first input conductor 510 and the second input conductor 540 are adjacent to each other while maintaining the shape.

The second magnetic flux reduction conductor 920 covers the gap G2 between the first input connection portion 530 and the second input connection portion 560. That is, the second magnetic flux reduction conductor 920 is disposed opposite to the input section 500 in an electrically insulated state to cover the gap G2 over the first input conductor 510 and the second input conductor 540. The reinforcing portion 80 is interposed between the second magnetic flux reduction conductor 920 and the input section 500 and the reinforcing portion 80 ensures an insulating distance between the second magnetic flux reduction conductor 920 and the input section 500.

### (Operation and effect)

In the power module 20 according to the above-described embodiment, the first magnetic flux reduction conductor 910 is disposed on the side opposite to the base plate 30 of the input section 500 and the second magnetic flux reduction conductor 920 is disposed between the input section 500 and the base plate 30. Accordingly, there is no need to use part of the base plate 30 to which the circuit board 40 is fixed as the second magnetic flux reduction conductor 920. Thus, the second magnetic flux reduction conductor 920 is not affected by heat transmitted from the circuit board 40 to the base plate 30. Further, the degree of freedom in designing the second magnetic flux reduction conductor 920 can be increased.

[Other embodiments] Although the embodiments of the present disclosure have been described above in detail with reference to the drawings, the specific configuration is not limited to the configuration of the embodiment, and additions, omissions, substitutions, and other changes to the configuration are possible without departing from the gist of the present disclosure. Further, the present disclosure is not limited by the embodiment, but only by the claims.

In the above-described embodiments, the present disclosure is not limited to a configuration in which the first surface 30a and the second surface 30b of the base plate 30, the front surface 41a and the back surface 41b of the circuit board body 41, the first distal end surfaces 52b and 520b and the first proximal end surfaces 52a and 520a of the P-type terminals 52 and 520, and the second distal end surfaces 55b and 550b and the second proximal end surfaces 55a and 550a of the N-type terminals 55 and 550 are in a back-to-back relationship and in parallel to each other and these members may be slightly inclined.

In the above-described embodiments, an inverter has been described as an example of the power conversion device 1, but the power conversion device 1 is not limited to the inverter. The power conversion device 1 may be a device that performs power conversion using the power semiconductor element 60, such as a converter or a combination of an inverter and a converter. When the power conversion device 1 is a converter, a configuration may be employed in which AC voltage is input from an external input power supply (not illustrated) to the external output conductor 70, the AC voltage is converted into DC voltage by the power semiconductor element 60, and the DC voltage from the power semiconductor element 60 is output from the input section 50.

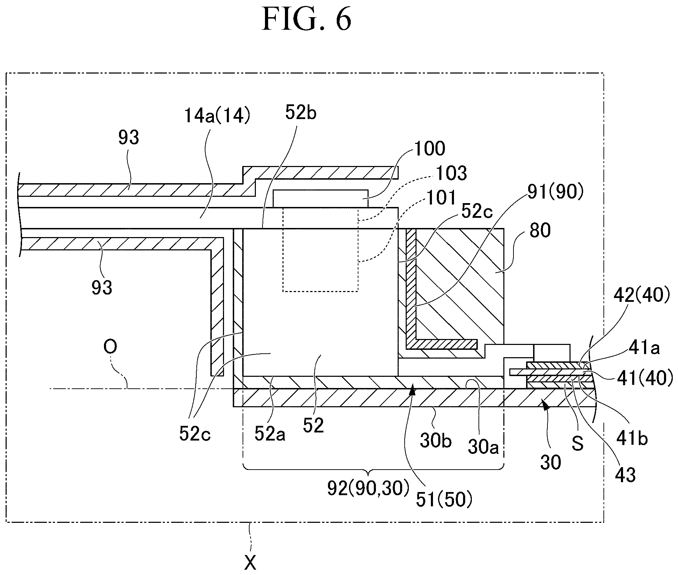

Further, as illustrated in FIG. 6, the power conversion device 1 may further include a third magnetic flux reduction conductor 93 which is disposed in opposite to the gap G1 existing between two first and second connection conductors 14a and 14b (not illustrated in FIG. 6). The third magnetic flux reduction conductor 93 is disposed in opposite to the first connection conductor 14a and the second connection conductor 14b in an insulated state to cover the gap G1 over the first connection conductor 14a and the second connection conductor 14b. More specifically, the pair of third magnetic flux reduction conductors 93 are arranged to sandwich the first connection conductor 14a and the second connection conductor 14b and an insulating distance between the third magnetic flux reduction conductor 93 and the connection conductor 14 is ensured. Accordingly, parasitic inductance in the current path of the input side connection conductor 14 that connects the capacitor 12 and the power module 20 can be further reduced. Therefore, power loss occurring within the power conversion device 1 can be suppressed.

Further, in the first embodiment, the second magnetic flux reduction conductor 92 constitutes part of the base plate 30, but the present disclosure is not limited to this configuration. For example, a configuration may be employed in which the second magnetic flux reduction conductor 92 is interposed between the base plate 30 and the first and second input conductors 51 and 54.

[Appendix] The power modules described in the embodiments are understood, for example, as below.

(1) The power module 20 according to a first aspect is a power module 20 for converting input voltage and outputting the converted voltage including: the input section 50 which includes the first input conductor 51 having the P-type terminal 52 and the second input conductor 54 having the N-type terminal 55 connected to a DC power supply together with the P-type terminal 52 and provided in parallel to the first input conductor 51 with the gap G2 interposed therebetween; the circuit board 40 which includes the power semiconductor element 60 converting DC voltage from the input section 50 into AC voltage; the output conductor which outputs the AC voltage from the power semiconductor element 60; and the magnetic flux reduction conductors 90 and 900 which are arranged in opposite to the input section 50 in an insulated state to cover the gap G2 over the first input conductor 51 and the second input conductor 54.
According to the above-described configuration, the magnetic flux reduction conductors 90 and 900 are affected by the magnetic flux leaking from this gap G2, and an eddy current as an induced current flows through the magnetic flux reduction conductors 90 and 900. Then, this eddy current generates a magnetic flux that cancels out the magnetic flux generated in the input sections 50 and 500. Thus, the magnetic flux reduction conductors 90 and 900 can form a magnetic field that corresponds to the magnitude of the current flowing through the input sections 50 and 500, that is, the magnitude of the magnetic field.

(2) The power module 20 according to a second aspect is the power module 20 of the first aspect, wherein the magnetic flux reduction conductors 90 and 900 includes the first magnetic flux reduction conductors 91 and 910 and the second magnetic flux reduction conductors 92 and 920 which are arranged to sandwich the input sections 50 and 500.

According to the above-described configuration, the magnetic flux reduction conductors 90 and 900 can more effectively cancel the magnetic flux leaking from the gap G2.

(3) The power module 20 according to a third aspect is the power module 20 of the second aspect, further including: the base plate 30 of the conductor to which the circuit board 40 is fixed, wherein the first magnetic flux reduction conductor 91 may be disposed on the side opposite to the base plate 30 of the input section 50 and the second magnetic flux reduction conductor 92 may be part of the base plate 30.

According to the above-described configuration, the base plate 30 to which the circuit board 40 is fixed can be used as the magnetic flux reduction conductor 90. Therefore, there is no need for major design changes or addition of new members.

(4) The power module 20 according to a fourth aspect is the power module 20 of the second aspect, further including: the base plate 30 of the conductor to which the circuit board 40 is fixed, wherein the first magnetic flux reduction conductors 91 and 910 may be arranged on the side opposite to the base plate 30 of the input sections 50 and 500 and the second magnetic flux reduction conductors 92 and 920 may be arranged between the input sections 50 and 500 and the base plate 30.

According to the above-described configuration, there is no need to use part of the base plate 30 to which the circuit board 40 is fixed as the second magnetic flux reduction conductors 92 and 920. Thus, the second magnetic flux reduction conductors 92 and 920 are not affected by heat transmitted from the circuit board 40 to the base plate 30.

### Industrial Applicability

According to the present disclosure, it is possible to provide a power module capable of reducing parasitic inductance occurring in an input side conductor.

### Reference Signs List

1 Power conversion device
10 Casing
10a Input side surface
10b Output side surface
11 External input conductor
12 Capacitor
13 Power conversion unit
14 Connection conductor
14a First connection conductor
14b Second connection conductor
15 Cooling device
20 Power module
30 Base plate
30a First surface
30b Second surface
40 Circuit board
41 Circuit board body
41a Front surface
41b Back surface
42 Circuit pattern
43 Copper pattern 50, 500 Input section
51, 510 First input conductor
52, 520 P-type terminal
52a, 520a First proximal end surface
52b, 520b First distal end surface
52c First side surface
53, 530 First input connection portion
54, 540 Second input conductor
55, 550 N-type terminal
55a, 550a Second proximal end surface
55b, 550b Second distal end surface
55c Second side surface
56, 560 Second input connection portion
60 Power semiconductor element
70 External output conductor (output conductor)
80 Reinforcing portion
90, 900 Magnetic flux reduction conductor
91, 910 First magnetic flux reduction conductor
92, 920 Second magnetic flux reduction conductor
93 Third magnetic flux reduction conductor
100 Bolt
101 Screw hole
102, 103 Fastening hole
G1, G2 Gap
O Reference line
P Potting space
S Bonding material
X Reference plane

## Claims

1. A power module (20) for converting input voltage and outputting the converted voltage, comprising:
an input section (50;500) which includes a first input conductor (51;510) having a P-type terminal (52;520) and a first input connection portion (53) and a second input conductor (54;540) having an N-type terminal (55;550) and a second input connection portion (56) connectable to a DC power supply together with the P-type terminal (52;520) and provided in parallel to the first input conductor (51;510) with a gap (G1;G2) interposed therebetween;
a circuit board (40) which includes a power semiconductor element (60) converting DC voltage from the input section (50;500) into AC voltage; and
an output conductor (70) configured to output the AC voltage from the power semiconductor element (60); wherein
the first input connection portion (53) is an electrical conductor which is configured to connect the P-type terminal (52) and the circuit board (40) and serves as part of a current path of an input current,
the second input connection portion (56) is an electrical conductor which is configured to connect the N-type terminal (55) and the circuit board (40) and serves as part of the current path of the input current, and
the P-type terminal (52) and the N-type terminal (55) are arranged to be symmetrical to the first input connection portion (53) and the second input connection portion (56) with respect to a reference plane (X),
the power module (20) further comprising:
a magnetic flux reduction conductor (90;900) which is disposed opposite to the input section (50;500) in an insulated state to cover the gap (G1;G2) over the first input conductor (51;510) and the second input conductor (54;540); and
a reinforcing portion (80) which is made of a synthetic resin material and mechanically reinforces the input section (50;500) and the external output conductor (70),
wherein the magnetic flux reduction conductor (90;900) includes a first magnetic flux reduction conductor (91;910) and a second magnetic flux reduction conductor (92;920) which are arranged to sandwich the input section (50;500),
wherein the first magnetic flux reduction conductor (91;910) is embedded inside the reinforcing portion (80),
wherein the first magnetic flux reduction conductor (91;910) has an L-shaped cross-section when viewed from the reference plane (X) and is extended in a direction in which the first input conductor (51;510) and the second input conductor (54;540) are adjacent to each other, and
the reinforcing portion (80) is interposed between the first magnetic flux reduction conductor (91;910) and the input section (50;500) and between the second magnetic flux reduction conductor (92) and the input section (50; 500).

2. The power module (20) according to claim 1, further comprising:
a base plate (30) of a conductor to which the circuit board (40) is fixed,
wherein the first magnetic flux reduction conductor (91;910) is disposed on the side opposite to the base plate (30) of the input section (50;500), and
wherein the second magnetic flux reduction conductor (92;920) is part of the base plate (30).

3. The power module (20) according to claim 1, further comprising:
a base plate (30) of a conductor to which the circuit board (40) is fixed,
wherein the first magnetic flux reduction conductor (91;910) is disposed on the side opposite to the base plate of the input section (50;500), and
wherein the second magnetic flux reduction conductor (92;920) is disposed between the input section (50;500) and the base plate (30).

## Patentansprüche

1. Leistungsmodul (20) zum Umwandeln einer Eingangsspannung und Ausgeben der umgewandelten Spannung, umfassend:
einen Eingangsabschnitt (50; 500), der einen ersten Eingangsleiter (51; 510) mit einem P-Typ-Anschluss (52; 520) und einem ersten Eingangsverbindungsabschnitt (53) sowie einen zweiten Eingangsleiter (54; 540) mit einem N-Typ-Anschluss (55; 550) und einem zweiten Eingangsverbindungsabschnitt (56) beinhaltet, der mit einer DC-Leistungsversorgung zusammen mit dem P-Typ-Anschluss (52; 520) verbindbar und parallel zu dem ersten Eingangsleiter (51; 510) bereitgestellt ist, wobei ein Spalt (G1; G2) dazwischen angeordnet ist;
eine Leiterplatte (40), die ein Leistungshalbleiterelement (60) beinhaltet, das die DC-Spannung aus dem Eingangsabschnitt (50; 500) in eine AC-Spannung umwandelt; und
einen Ausgangsleiter (70), der konfiguriert ist, die AC-Spannung von dem Leistungshalbleiterelement (60) auszugeben; wobei
der erste Eingangsverbindungsabschnitt (53) ein elektrischer Leiter ist, der konfiguriert ist, den P-Typ-Anschluss (52) und die Leiterplatte (40) zu verbinden, und als Teil eines Strompfades eines Eingangsstroms dient,
der zweite Eingangsverbindungsabschnitt (56) ein elektrischer Leiter ist, der konfiguriert ist, den N-Typ-Anschluss (55) und die Leiterplatte (40) zu verbinden, und als Teil des Strompfades des Eingangsstroms dient, und
der P-Typ-Anschluss (52) und der N-Typ-Anschluss (55) so angeordnet sind, dass sie symmetrisch zu dem ersten Eingangsverbindungsabschnitt (53) und dem zweiten Eingangsverbindungsabschnitt (56) in Bezug auf eine Referenzebene (X) sind,
wobei das Leistungsmodul (20) ferner umfasst:
einen Magnetfluss-Reduktionsleiter (90; 900), der gegenüberliegend bzw. entgegengesetzt zu dem Eingangsabschnitt (50; 500) in einem isolierten Zustand angeordnet ist, um den Spalt (G1; G2) über dem ersten Eingangsleiter (51; 510) und dem zweiten Eingangsleiter (54; 540) abzudecken; und
einen Verstärkungsabschnitt (80), der aus einem Kunstharzmaterial besteht und den Eingangsabschnitt (50; 500) sowie den externen Ausgangsleiter (70) mechanisch verstärkt,
wobei der Magnetfluss-Reduktionsleiter (90; 900) einen ersten Magnetfluss-Reduktionsleiter (91; 910) und einen zweiten Magnetfluss-Reduktionsleiter (92; 920) beinhaltet, die so angeordnet sind, dass sie den Eingangsabschnitt (50; 500) sandwichartig umgeben,
wobei der erste Magnetfluss-Reduktionsleiter (91; 910) in den Verstärkungsabschnitt (80) eingebettet ist,
wobei der erste Magnetfluss-Reduktionsleiter (91; 910) bei Betrachtung von der Referenzebene (X) aus einen L-förmigen Querschnitt aufweist und sich in einer Richtung erstreckt, in welcher der erste Eingangsleiter (51; 510) und der zweite Eingangsleiter (54; 540) angrenzend bzw. benachbart zueinander sind, und
der Verstärkungsabschnitt (80) zwischen dem ersten Magnetfluss-Reduktionsleiter (91; 910) und dem Eingangsabschnitt (50; 500) sowie zwischen dem zweiten Magnetfluss-Reduktionsleiter (92) und dem Eingangsabschnitt (50; 500) angeordnet ist.

2. Leistungsmodul (20) nach Anspruch 1, ferner umfassend:
eine Basisplatte (30) eines Leiters bzw. aus einem Leiter, an der die Leiterplatte (40) befestigt ist,
wobei der erste Magnetfluss-Reduktionsleiter (91; 910) auf der der Basisplatte (30) gegenüberliegenden bzw. entgegengesetzten Seite des Eingangsabschnitts (50; 500) angeordnet ist, und
wobei der zweite Magnetfluss-Reduktionsleiter (92; 920) Teil der Basisplatte (30) ist.

3. Leistungsmodul (20) nach Anspruch 1, ferner umfassend:
eine Basisplatte (30) eines Leiters bzw. aus einem Leiter, an der die Leiterplatte (40) befestigt ist,
wobei der erste Magnetfluss-Reduktionsleiter (91; 910) auf der der Basisplatte gegenüberliegenden bzw. entgegengesetzten Seite des Eingangsabschnitts (50; 500) angeordnet ist, und
wobei der zweite Magnetfluss-Reduktionsleiter (92; 920) zwischen dem Eingangsabschnitt (50; 500) und der Basisplatte (30) angeordnet ist.

## Revendications

1. Module de puissance (20) permettant de convertir une tension d'entrée et d'émettre la tension convertie, comprenant :
une section d'entrée (50 ; 500) qui inclut un premier conducteur d'entrée (51 ; 510) ayant une borne de type P (52 ; 520) et une première partie de connexion d'entrée (53) et un second conducteur d'entrée (54 ; 540) ayant une borne de type N (55 ; 550) et une seconde partie de connexion d'entrée (56) pouvant être connectée à une alimentation en CC conjointement avec la borne de type P (52 ; 520) et disposée en parallèle au premier conducteur d'entrée (51 ; 510) avec un espace (G1 ; G2) interposé entre eux ;
une carte de circuit imprimé (40) qui inclut un élément semi-conducteur de puissance (60) convertissant une tension en CC provenant de la section d'entrée (50 ; 500) en tension en CA ; et
un conducteur de sortie (70) configuré pour émettre la tension CA à partir de l'élément semi-conducteur de puissance (60) ; dans lequel la première partie de connexion d'entrée (53) est un conducteur électrique qui est configuré pour connecter la borne de type P (52) et la carte de circuit imprimé (40) et sert de partie d'un trajet de courant d'un courant d'entrée,
la seconde partie de connexion d'entrée (56) est un conducteur électrique qui est configuré pour connecter la borne de type N (55) et la carte de circuit imprimé (40) et sert de partie du trajet de courant du courant d'entrée, et
la borne de type P (52) et la borne de type N (55) sont agencées pour être symétriques à la première partie de connexion d'entrée (53) et à la seconde partie de connexion d'entrée (56) par rapport à un plan de référence (X), le module de puissance (20) comprenant en outre :
un conducteur de réduction de flux magnétique (90 ; 900) qui est disposé à l'opposé de la section d'entrée (50 ; 500) dans un état isolé pour couvrir l'espace (G1 ; G2) sur le premier conducteur d'entrée (51 ; 510) et le second conducteur d'entrée (54 ; 540) ; et
une partie de renforcement (80) qui est composée d'un matériau en résine synthétique et renforce mécaniquement la section d'entrée (50 ; 500) et le conducteur de sortie externe (70),
dans lequel le conducteur de réduction de flux magnétique (90 ; 900) inclut un premier conducteur de réduction de flux magnétique (91 ; 910) et un second conducteur de réduction de flux magnétique (92 ; 920) qui sont agencés pour intercaler la section d'entrée (50 ; 500),
dans lequel le premier conducteur de réduction de flux magnétique (91 ; 910) est incorporé à l'intérieur de la partie de renforcement (80),
dans lequel le premier conducteur de réduction de flux magnétique (91 ; 910) présente une section en forme de L lorsqu'il est vu à partir du plan de référence (X) et s'étend dans une direction dans laquelle le premier conducteur d'entrée (51 ; 510) et le second conducteur d'entrée (54 ; 540) sont adjacents l'un à l'autre, et
la partie de renforcement (80) est interposée entre le premier conducteur de réduction de flux magnétique (91 ; 910) et la section d'entrée (50 ; 500) et entre le second conducteur de réduction de flux magnétique (92) et la section d'entrée (50 ; 500).

2. Module de puissance (20) selon la revendication 1, comprenant en outre :
une plaque de base (30) d'un conducteur à laquelle la carte de circuit imprimé (40) est fixée,
dans lequel le premier conducteur de réduction de flux magnétique (91 ; 910) est disposé sur le côté opposé à la plaque de base (30) de la section d'entrée (50 ; 500), et
dans lequel le second conducteur de réduction de flux magnétique (92 ; 920) fait partie de la plaque de base (30).

3. Module de puissance (20) selon la revendication 1, comprenant en outre :
une plaque de base (30) d'un conducteur à laquelle la carte de circuit imprimé (40) est fixée,
dans lequel le premier conducteur de réduction de flux magnétique (91 ; 910) est disposé sur le côté opposé à la plaque de base de la section d'entrée (50 ; 500), et
dans lequel le second conducteur de réduction de flux magnétique (92 ; 920) est disposé entre la section d'entrée (50 ; 500) et la plaque de base (30).
